# EUROPEAN PATENT APPLICATION

(11) **EP 4 482 031 A1**
(43) Date of publication of application: **25.12.2024**
(21) Application number: 23209720.4
(22) Date of filing: 14.11.2023
(51) Int. Cl.: H03H 9/02, H03B 5/04, H03B 5/36, H03B 5/06

(54) **ENHANCING TEMPERATURE STABILITY IN REFERENCE CLOCK APPLICATIONS USING RESONATOR ARRAYS**

(30) Priority: 23.06.2023 US 202318340794
(71) Applicant: INTEL Corporation, Santa Clara, CA 95054 (US)
(72) Inventor: CARLTON, Brent, Portland, 97229 (US); MIX, Jason, Portland, 97229 (US); ABDELMONEUM, Mohamed, Portland, 97229 (US); HUUSARI, Timo, Hillsboro, 97124 (US); LIU, Renzhi, Portland, 97229 (US); VIDANA MORALES, Ruth, 45060 Zapopan (MX); SHAHRAINI, Sarah, Newcastle, 98056 (US)
(74) Representative: HGF

(57) **Abstract**

Embodiments herein relate to a reference clock that includes an array of resonators with different turnover temperatures. The resonators may be Microelectromechanical Systems (MEMS) resonators with different doping concentrations, or quartz crystal resonators with different cut angles, for example. For MEMS resonators in particular, the turnover temperature can be adjusted by providing an overlying oxide layer with different thicknesses. In another approach, the resonators are piezoelectric-on-silicon resonators with different finger pitch-to-thickness ratios. A control circuit obtains a sensed temperature from a temperature sensor and selects one of the resonators having a turnover temperature in a temperature range corresponding to the sensed temperature. Each resonator may have a turnover temperature in a different temperature range. The resonators may have separate drivers or have a common driver.

## Description

### FIELD

The present application generally relates to a clock generator and, more particularly, to a clock generator which uses resonators.

### BACKGROUND

A clock generator is an electronic oscillator that produces a clock signal on an integrated circuit or chip. The clock signal, also referred to as a reference clock, is provided to synchronize the operation of different circuits on the chip. In some cases, other clocks are derived from the reference clock and distributed on a chip. Generally, a reference clock can be distributed to one or more chips. A clock generator can include a quartz crystal resonator or a Microelectromechanical Systems (MEMS) resonator, for instance, which vibrates at a specific resonant frequency when excited by a signal from a driver. However, various challenges are presented in maintaining a stable frequency of the clock signal in different conditions.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts an example reference oscillator circuit 100 that has one driver and three resonators, in accordance with various embodiments.
FIG. 2 depicts an example reference oscillator that has a separate driver for each of three resonators, in accordance with various embodiments.
FIG. 3A depicts an example plot of frequency drift versus temperature for an uncompensated MEMS resonator, in accordance with various embodiments.
FIG. 3B depicts an example resonator device 305 which includes a MEMS resonator 311 formed on a substrate 310, and an oxide layer 312 formed on the MEMS resonator 311, in accordance with various embodiments.
FIG. 3C depicts an example resonator device 345 which includes interdigitated electrodes 350 and 360 in a MEMS resonator formed on a substrate 340.
FIG. 4 depicts an example plot of frequency drift versus temperature for an array of resonators, consistent with FIGs. 1 and 2, in accordance with various embodiments.
FIG. 5 depicts another example plot of frequency drift versus temperature for an array of resonators, in accordance with various embodiments.
FIG. 6 depicts an example reference oscillator that has one driver and two resonators, in accordance with various embodiments.
FIG. 7 depicts an example plot of frequency drift versus temperature for an array of resonators, consistent with FIG. 6, in accordance with various embodiments.
FIG. 8 depicts an example plot of an output voltage (Xout) versus time for the reference oscillator of FIG. 6, where a second resonator is added at different times, in accordance with various embodiments.
FIG. 9 depicts a flowchart of an example process for selecting a resonator in an array of resonators, in accordance with various embodiments.
FIG. 10 depicts example switching signals during a transition, consistent with FIG. 9, in accordance with various embodiments.
FIG. 11 illustrates an example of components that may be present in a computing system 1150 for implementing the techniques (e.g., operations, processes, methods, and methodologies) described herein.

### DETAILED DESCRIPTION

As mentioned at the outset, various challenges are presented in maintaining a stable frequency of a clock signal of an oscillator circuit.

Reference oscillators are essentially feedback amplifiers that utilize a frequency selective component (either a quartz or MEMS resonator, for example) in the feedback loop. This component only allows signal to pass through at its resonance frequency, which creates a positive loop and generates a sine wave oscillation at the same frequency as the resonator. The thermal stability of the oscillator is largely dependent on the stability of the frequency selective component.

These oscillators may be arranged, e.g., in an integrated circuit, a System in Package (SiP), a System on a Chip (SoC), or a stacked tile/chiplet design which includes multiple integrated circuits/chips within the same package.

To meet consumer demands for high performance and low power, computing systems require high-frequency reference oscillators with low jitter and minimal power consumption. Quartz resonators offer superior thermal stability compared to their MEMS counterparts, but their resonance frequency is limited to a few hundred MHz, and they cannot be fabricated on a complementary metal-oxide semiconductor (CMOS) chip leading to increased routing parasitics. These parasitics are specifically critical for high frequency reference clock applications. On the other hand, MEMS resonators are suitable for high frequency reference clock applications. They can achieve resonance frequencies of up to a few GHz and have the potential to be fabricated on the same chip as the oscillator driver, resulting in smaller parasitics. However, their thermal stability falls in the range of a few thousand ppm (parts per million) for the commercial temperature range of-40°C to 80°C, compared to less than 100 ppm for quartz crystals under the same conditions.

A possible solution involves active temperature compensation techniques such as ovenization or temperature sensing, combined with frequency correction through a fractional phase-locked loop (PLL). However, these techniques can increase the overall power budget, reduce performance and add to the fabrication complexity. The need for high vacuum packaging can also increases the cost of the oscillator. Additionally, the fractional PLL method may add to the overall jitter of the reference clock due to the additional PLL. Moreover, although PLLs can generate any frequency, it is at the expense of power consumption and jitter degradation.

Another possible solution involves using passive temperature compensation techniques such as adding dopants to the resonator material layers or adding an additional positive temperature coefficient of elasticity (TCE) layer such as silicon dioxide to the resonator structure. However, these techniques can also have limitations in achieving the desired level of temperature stability. For example, the final temperature stability may still be larger than that of quartz crystals, which can be a concern for some applications.

The solutions provided herein address the above and other challenges. In one aspect, the solutions provide an array of resonators with similar frequencies but varying turnover temperatures. The turnover temperature is the specific temperature on a second-order curve of the temperature coefficient of frequency (TCF) versus temperature plot, where the polarity of frequency change transitions from positive to negative (the maximum point in the TCF vs temperature curve). The temperature range is divided into smaller sections based on the number of resonators in the array. For example, if there are three resonators, the entire temperature range is divided into three smaller sections, each corresponding to one resonator. Each resonator is optimized to provide a turn-over temperature in the middle of each smaller section. The solutions also include a temperature sensor and also circuitry for switching between the resonators, to select which resonator to be connected to the oscillator driver at different temperature ranges. As a result, a very high frequency stability of under 100 parts per million (ppm), for instance, can be achieved. The solutions take advantage of the fact that the frequency drift versus temperature for MEMS-based resonators such as piezoelectric, piezoelectric-on-silicon, and silicon resonators follows a second-order quadratic curve with a minimal frequency drift within the temperature range close to the resonator's turnover temperature. The resonators can be MEMS resonators, for example, which typically have a size of around 200 µm x 200 µm. An array of three of these resonators, for example, would have a size of less than 1 mm x 1 mm, which is smaller than a typical single quartz crystal.

For MEMS resonators in particular, the turnover temperature can be adjusted by providing an overlying silicon oxide layer with different thicknesses or adding doping to the Silicon resonators. For the quartz crystals, the turn over temperature can be adjusted with choosing the proper angle for the crystal. A control circuit obtains a sensed temperature from a temperature sensor and selects one of the resonators having a turnover temperature corresponding to the sensed temperature. Each resonator may correspond to a different temperature range. The resonators may have separate drivers or have a common driver. A transition between resonators may involve injecting the signal of the current driver into the newly-selected resonator to accelerate a start-up time and minimize a phase difference during switching.

The solutions provided herein overcome the limitation of MEMS resonators in the context of reference clock applications, thereby facilitating the realization of a reference clock in the GHz range. A high-frequency reference clock advantageously exhibits reduced jitter and faster start-up time in comparison to a low-frequency reference clock.

These and other features will be further apparent in view of the following discussion.

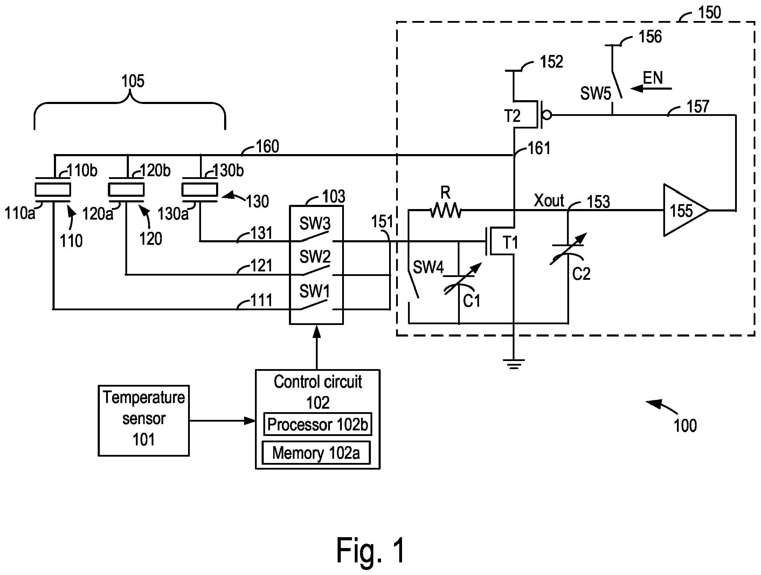

FIG. 1 depicts an example reference oscillator circuit 100 that has one driver 150 (a single driver) and three resonators 110, 120 and 130, in accordance with various embodiments. The block diagram is of a reference oscillator with an array of MEMS resonators connected as frequency selective components. The term oscillator is typically used to refer to the combination of a driver and a resonator. The resonators are arranged in parallel in an array 105. Generally, the array can include at least two resonators. The resonators are of the same type, in one approach. One or more of the resonators can be driven by the driver at a time. In one approach, a set of switches 103, including switches SW1, SW2 and SW3, is provided to route a drive or excitation signal from the driver to the resonators 110, 120 and 130, respectively. The set of switches may be controlled by a control circuit 102, which in turn is responsive to temperature data/readings from a temperature sensor 101. The control circuit may include a memory 102a for storing instructions and a processor 102b for executing the instructions to provide the functions described herein.

Examples of temperature sensors include a silicon bandgap temperature sensor, a thermistor, a resistive temperature detector and a thermocouple. A silicon bandgap temperature sensor include a forward biased p-n junction in which a change in a base-to-emitter voltage corresponds to the device temperature. A thermistor is a passive component that changes resistance with temperature. A resistive temperature detector is made of pure material such as platinum, nickel, or copper, with a highly predictable resistance-temperature relationship. A thermocouple is made of two dissimilar electrical conductors that form electrical junctions at different temperatures. A thermocouple produces a temperature-dependent voltage as a result of the thermoelectric Seebeck effect. A MEMS based temperature sensor could be used as well. In general, any type of temperature sensor could be used.

In one approach, the switches comprises transistors which can be turned on (made conductive) or off (made non-conductive) by controlling their control gate voltages. In another approach, the switches comprises relay switches. When turned on, each switch couples the driver to a path 111, 121 or 131 to excite the resonator 110, 120 or 130, respectively, and formed a closed feedback loop with the driver. The switches are coupled to the driver and to one another at a path 151. The path 151 is coupled to a resistor R and a path 153 which carries an output signal Xout (the reference clock signal) of the driver. A voltage on the path 151 is applied to the control gate of a first transistor T1 which is in series with a second transistor T2. The series-connected transistors are coupled to a power supply node 152. The path 151 is also coupled to ground via a switch SW4 and a first variable capacitor C1. Path 153 is coupled to ground via a second variable capacitor C2 and to the input of an amplifier control 155. The output of the amplifier control is coupled to a power supply node 156 via a path 157 and switch SW5, which is controlled by an enable (EN) signal. EN is used to enable the driver 150. The path 157 is coupled to the control gate of the transistor T2. In this implementation, T1 is an n-type metal-oxide-semiconductor field-effect transistor (MOSFET) and T2 is a p-type MOSFET.

The resonators are coupled at a first side to the respective path and switch and at an opposing second side to a common path 160 which, in turn, is coupled to a point 161 between T1 and T2. For example, the resonator 110 may have first and second sides 110a and 110b, respectively. The resonator 120 may have first and second sides 120a and 120b, respectively. The resonator 130 may have first and second sides 130a and 130b, respectively. The opposing sides may be electrodes, for example.

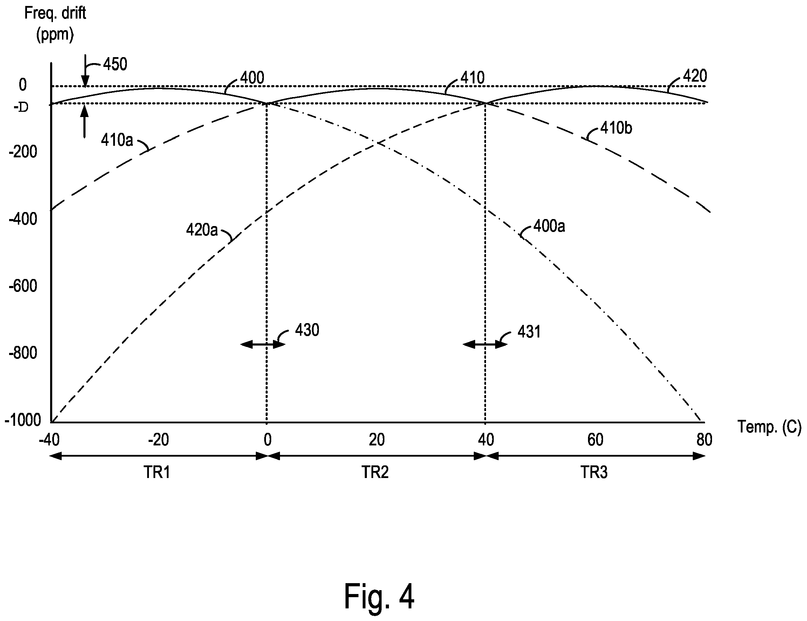

The circuit 100 thus replaces a solitary resonator with an array of resonators featuring distinct turnover temperatures. The resonators are MEMS resonators, in one possible implementation. In another possible implementation, the resonators are quartz crystals. The entire temperature range over which the circuit is to operate can be divided into smaller segments, such as depicted in FIGs. 4, 5 and 7, and based on a temperature measured by the temperature sensor (which may be an undoped resonator or another type of temperature sensor), one of the resonators that possesses the turnover temperature in that range will be linked to the oscillator driver. For example, the frequency of a mechanical resonator can be affected by temperature. By comparing the frequency change of a resonator with that of another resonator, it is possible to measure the corresponding change in temperature.

Moreover, the variable load capacitors can be used to adjust the center frequency of the resonator array to be similar at room temperature. -For example, the center frequency of a mechanical resonator is its natural resonance frequency and is independent of the turnover temperature. A goal is to have the same natural resonance frequency for all resonators in the array. However, during the fabrication process, slight variations in size can cause the resonators in the array to have slightly different natural resonance frequencies (center frequencies). To achieve the desired frequency consistency, calibration is performed. This involves adjusting the resonators by adding a load to bring their resonance frequencies to the exact value desired. The variable load capacitor is employed for this purpose, as it allows fine-tuning and precise adjustment of the resonance frequency for each resonator in the array.

The driver 150 in this example is a Pierce oscillator, but other driver architectures could be used. Additionally, the number of the resonators in the array can be optimized based on the level of stability needed. A larger number of resonators results in a greater stability, in terms of a stable oscillation frequency.

In an oscillator circuit, a resonator and a driver work together to generate and sustain oscillations at a desired frequency. The resonator determines the frequency of oscillation, while the driver provides the necessary energy to maintain the oscillations. The resonator is a component that exhibits resonance at a specific frequency. When driven at this frequency, it can store and exchange energy between capacitive elements, creating oscillations. The driver is an active component, such as an operational amplifier, that supplies energy to the resonator to compensate for the energy losses in the circuit. It amplifies the signal generated by the resonator and provides the necessary power to sustain the oscillations. The driver also shapes the waveform and ensures the stability and reliability of the oscillations.

The oscillator circuit includes a feedback loop that connects the output of the driver back to the resonator. This feedback loop enables the circuit to sustain oscillations by continuously reinforcing the resonator's natural frequency. The driver amplifies the signal from the resonator and feeds it back into the resonator, effectively providing positive feedback. This feedback helps to compensate for energy losses and maintains the desired oscillation frequency.

When power is initially applied to the oscillator circuit, it would start oscillating on its own but the startup time would be relatively long such as in milliseconds. Instead, an initial signal can be provided to kick-start the oscillations to reduce the startup time to, e.g., microseconds. This can be done by injecting a small signal or noise into the resonator, allowing the driver to amplify it and establish the oscillations. Once the oscillations are initiated, the feedback loop takes over and sustains the oscillations.

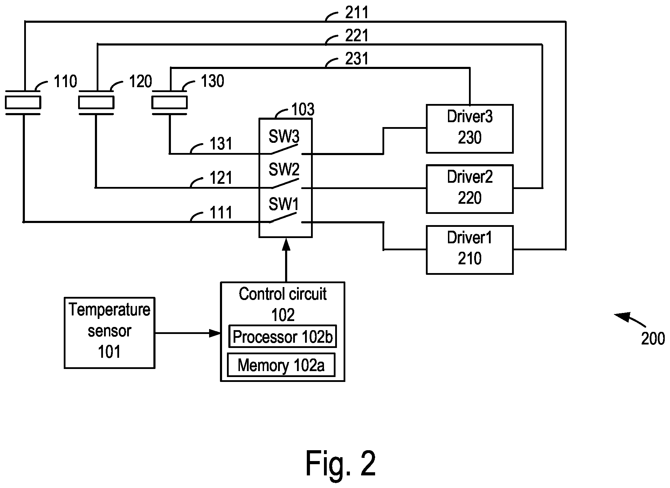

FIG. 2 depicts an example reference oscillator 200 that has a separate driver for each of three resonators, in accordance with various embodiments. In this example, a first driver, Driver1 210 can be coupled to the first resonator 110 by the respective switch SW1 and paths 111 and 211, a second driver, Driver2 220 can be coupled to the second resonator 120 by the respective switch SW2 and paths 121 and 221, and a third driver, Drivers 230 can be coupled to the third resonator 130 by the respective switch SW3 and paths 131 and 231. Each driver can have a similar configuration as the driver 150 of FIG. 1 but the drivers operate independently in driving the respective resonators. The choice of whether to have a common driver or separate drivers can be based on, e.g., the selected technique for transitioning between resonators, discussed further below.

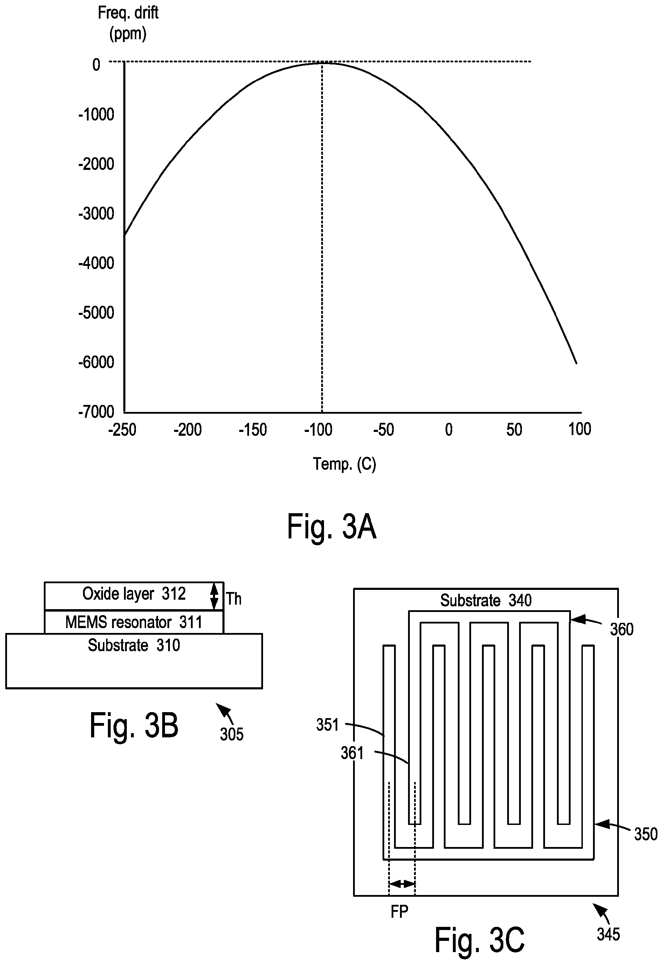

FIG. 3A depicts an example plot of frequency drift versus temperature for an uncompensated MEMS resonator, in accordance with various embodiments. The frequency drift or sensitivity is represented by a temperature coefficient of frequency (TCF) curve. TCF is the rate of change of frequency with temperature relative to a reference frequency. The MEMS resonator is uncompensated in that additional techniques are not used to shift the turnover temperature to higher levels. Frequency drift can be measured in parts per million. For example, if the clock frequency is 10 MHz, a drift of -1000 ppm corresponds to a drift of -10 KHz. MEMS resonators have a quadratic temperature stability. In this example, the turnover temperature is about -100 °C. Within a small temperature range around this turnover temperature, the frequency drift is negligible. However, this temperature is below the range at which most computing devices are used. The turnover temperature is the temperature at the peak of the plot, where the frequency drift is 0. The frequency drift increases on either side of the turnover temperature.

Various techniques can be used to shift the turnover temperature of MEMS resonators towards higher temperatures and into the desired commercial temperature range such as -40 to 80 °C. For example, for silicon and piezoelectric-on-silicon resonators, the turnover temperature can be shifted towards higher temperatures by incorporating doping into the silicon layer. Example dopants include Boron, Antimony, Arsenic and Phosphorus. Higher doping levels (dopant concentrations) can shift the turnover temperature higher. For example, with phosphorus, a doping concentration of 10^19 /cm3 could increase the turnover temperature to 90 °C, while no doping results in a turnover temperature of below -100 °C. Doping concentrations between zero and 10^19 /cm3 can result in turnover temperatures from below -100 °C to above 90 °C, for instance. The doping is believed to affect the elastic properties of the resonator. For instance, the silicon substrate 310 of FIG. 3B can be doped. In addition to the doping level, the turnover temperature position is dependent on the resonating mode shape as well. Accordingly, with the same doping level, two different mode shapes can have two different turnover temperatures. The resonators in an array could have different resonating mode shapes with the same or different doping concentration. In an example implementation, each resonator of the set of resonators comprises a Microelectromechanical Systems (MEMS) resonator, and a doping concentration is different for each MEMS resonator.

Another technique to shift the turnover temperature is to add a layer with a positive temperature coefficient of elasticity, such as silicon dioxide (SiO2), to the resonator. This technique also shifts the turnover temperature towards higher temperatures, and works for all types of MEMS resonators. For instance, the oxide layer 312 of FIG. 3B can be provided. A thicker oxide layer can result in a higher shift of the turnover temperature. In particular, a lower value of a flexural-stiffness ratio corresponds with a higher turnover temperature, where the flexural ratio refers to the flexural vibration mode of the resonator and can be defined as B(Si)/B(SiO2). B(Si) is the bending stiffness of the silicon substrate 310 and B(SiO2) is the bending stiffness of the SiO2 layer 312. A thicker SiO2 layer results in a higher B(SiO2), a smaller ratio and therefore a higher turnover temperature. The techniques provided herein can work for all mode shapes and not just the flexural mode (bending mode) explained here. Other mode shapes such as extensional mode, lamb mode, lame mode all would work with adding the oxide layer. In an example implementation, each resonator of the set of resonators comprises an oxide layer, and a thickness of each oxide layer is different.

Various types of MEMS resonators which may be used include clamped-clamped resonator, cantilever resonator, fixed-fixed beam resonator, square plate resonator, disc resonator, ring resonator and comb drive resonator.

Another technique to shift the turnover temperature is to adjust a finger pitch-to-thickness (FP/t) ratio. For example, for piezoelectric-on-silicon resonators, the position of the turnover temperature is dependent on the FP/t ratio. See also FIG. 3C. Therefore, the amount of doping, the thickness of the oxide layer, or the FP/t ratio can be adjusted to control the position of the turnover temperature. In an example implementation, each resonator of the set of resonators comprises a piezoelectric-on-silicon resonator, and a finger pitch to thickness (FP/t) ratio is different for each piezoelectric-on-silicon resonator.

By utilizing these techniques, it is possible to tailor the turnover temperature of the MEMS resonators to match the desired commercial temperature range.

FIG. 3B depicts an example resonator device 305 which includes a MEMS resonator 311 formed on a substrate 310, and an oxide layer 312 formed on the MEMS resonator 311, in accordance with various embodiments. As mentioned, the thickness (Th) of the oxide layer can be adjusted to adjust the turnover temperature of the resonator device.

FIG. 3C depicts an example resonator device 345 which includes interdigitated electrodes 350 and 360 in a MEMS resonator formed on a substrate 340. The electrodes include fingers such as example adjacent fingers 351 and 361, where a finger pitch (FP) is a distance between the centers of the adjacent fingers. The electrodes may be formed from a metal film having a thickness which is the dimension coming out of the page. The FP/t ratio can be defined as discussed, where this ratio can be adjusted to adjust the turnover temperature of the resonator device.

FIG. 4 depicts an example plot of frequency drift versus temperature for an array of resonators, consistent with FIGs. 1 and 2, in accordance with various embodiments. This is a temperature stability curve for an oscillator with an array of resonators. The plots 400 and 400a represent the frequency drift for a first resonator, such as resonator 110 in FIG. 2, the plots 410, 410a and 410b represent the frequency drift for a second resonator, such as resonator 120 in FIG. 2, and the plots 420 and 420a represent the frequency drift for a third resonator, such as resonator 130 in FIG. 2.

The first resonator is optimized for a low range of temperatures, e.g., -40 to 0 °C(temperature range TR1), where the plot 400 represents a minimal frequency drift, e.g., in a range 450 from 0 to -delta ppm. The plot 400a represents a larger frequency drift above this temperature range. However, these larger drifts are not realized if the first resonator is only used within its respective temperature range. The turnover temperature of the first resonator is -20 °C, which is at the center of TR1.

The second resonator is optimized for an intermediate range of temperatures, e.g., 0 to 40 °C (temperature range TR2), where the plot 410 represents a minimal frequency drift in the range 450. The plots 410a and 410b represent a larger frequency drift below and above, respectively, this temperature range. However, these larger drifts are not realized if the second resonator is only used within its respective temperature range. The turnover temperature of the second resonator is 20 °C, which is at the center of TR2.

The third resonator is optimized for a high range of temperatures, e.g., 40 to 80 °C(temperature range TR3), where the plot 420 represents a minimal frequency drift in the range 450. The plot 420a represents a larger frequency drift below this temperature range. However, these larger drifts are not realized if the third resonator is only used within its respective temperature range. The turnover temperature of the third resonator is 60 °C, which is at the center of TR3.

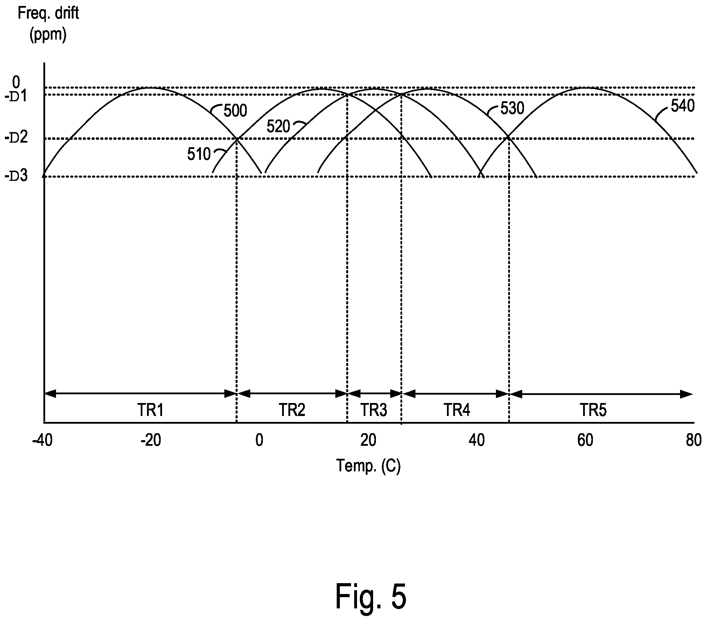

In this example, each temperature range is equal in width (e.g., 40 °C) but it is possible to have ranges with different widths. For example, the temperature ranges could be smaller around temperatures which are of most interest to provide an even smaller frequency drift. See FIG. 5, for example.

Additionally, the turnover temperature for each resonator is set to be at the center of its designated temperature range. The frequency drift for an array of resonators is represented by the solid lines 400, 410 and 420.

As shown in the plot, the temperature stability of the oscillator utilizing an array of MEMS resonators can be less than 100 ppm. If required, a larger array of resonators can be employed to further enhance the thermal stability of the oscillator.

Furthermore, a temperature hysteresis can be utilized to avoid undesirable frequent switching between resonators when the temperature is near the boundary (switching temperature) between adjacent temperature ranges. By applying a hysteresis, the temperature at which a given resonator switches to the oscillator driver will be offset from the switching temperature by a certain amount, allowing the oscillator to remain stable in the vicinity of the switching temperature. This can help to reduce the effects of noise and other environmental factors that may cause small fluctuations in temperature, which could otherwise trigger frequent switching between resonators.

For example, the arrows 430 and 431 represent hysteresis ranges or bands around the switching temperature of 0 °C and 40 °C, respectively. Assume the range is +/- 2 °C, for example. Thus, the switching from TR1 to TR2 will occur when the temperature exceeds 2°C, and the switching from TR2 to TR1 will occur when the temperature falls below-2 °C. Similarly, the switching from TR2 to TR3 will occur when the temperature exceeds 42 °C, and the switching from TR3 to TR2 will occur when the temperature falls below 38 °C. A hysteresis range can be associated with each switchover temperature, which is the temperature at the boundary between adjacent temperature ranges. The hysteresis ranges can be equal or different.

The temperature ranges are equal in width in this example but could have different widths. See FIG. 5. The turnover temperature may be centered within its corresponding temperature range, in one approach.

An additional or alternative limitation may be imposed by setting a timer when there is a switch in temperature ranges. For example, a specified/predetermined wait time may be imposed before switching to another resonator. A timer within the control circuit 102 can provide this wait time feature. The wait time feature should be used when a sudden, large temperature change is not expected as ir could reduce stability in this situation. The control circuit may also include logic to implement the hysteresis feature.

The technique provided herein are applicable to different types of resonators. In addition to MEMS resonators, the same concept of utilizing an array of resonators with different turnover temperatures to enhance temperature stability can be applied to quartz crystals as well. The turnover temperature of quartz crystals is determined by the quartz cut angle, which can be adjusted to achieve the desired turnover temperature. Therefore, an array of quartz crystals with different cut angles and corresponding turnover temperatures could be utilized in a similar manner as for MEMS resonators. By selecting the appropriate quartz crystal from the array based on the measured temperature, the frequency stability of the oscillator can be further improved. In an example implementation, each resonator of the set of resonators comprises a quartz crystal resonator, and a cut angle of each quartz crystal resonator is different.

FIG. 5 depicts another example plot of frequency drift versus temperature for an array of resonators, in accordance with various embodiments. In this example, there are five resonators with associated temperature ranges. Additional, the temperature ranges are not all equal in width. This approach provides different temperature regions with different levels of frequency drift. This can be useful when there is a temperature region of interest in which especially low drift is desired. Generally, smaller temperature ranges result in smaller frequency drifts. This can be the temperature region in which the device is most commonly operated, for example. The plots 500, 510, 520, 530 and 540 are for first through fifth resonators, respectively, and represent the frequency drift in first through fifth temperature ranges, respectively.

Here, the adjacent temperature ranges are TR1-TR5. The temperature range is smallest for TR3, second smallest for TR2 and TR4 and largest for TR1 and TR5. TR3 is the center region, TR2 and TR4 are adjacent to TR3 on opposing sides of TR3, and TR1 and TR5 are adjacent to TR2 and TR5, respectively. For example, TR1 is from -40 to -5 °C, TR2 is from -5 °C to 17 °C, TR3 is from 17 °C to 23 °C, TR4 is from 23 to 45 °C and TR5 is from 45 to 80 °C. The magnitude of the frequency drift is delta 1 for TR3, delta 2 from TR2 and TR4 and delta 3 for TR1 and TR5, where delta 1 <delta 2<delta 3. The scale of the y-axis is modified to show the frequency drift in greater detail. In this example, the plurality of temperature ranges are unequal in width and include a narrowest temperature range (TR3) adjacent to wider temperature ranges (TR2 and TR4)

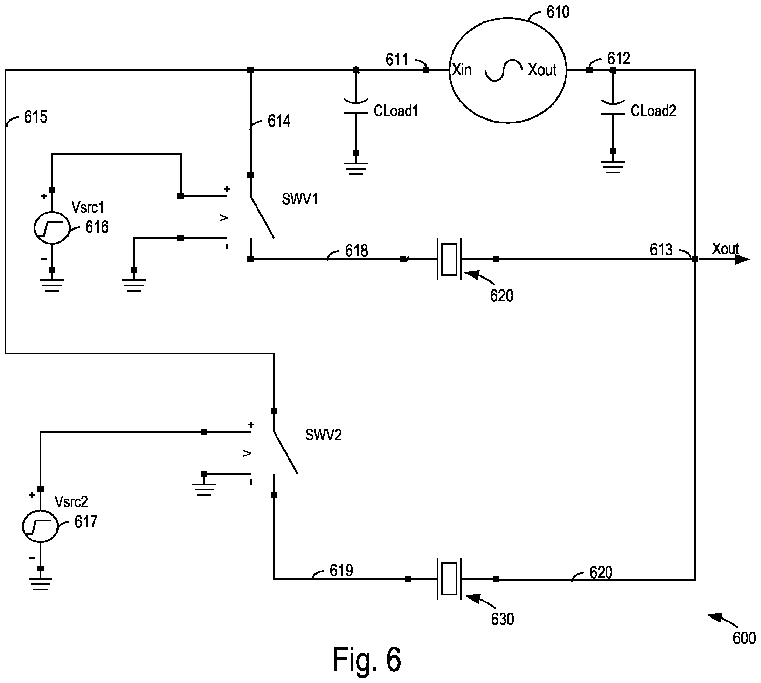

FIG. 6 depicts an example reference oscillator 600 that has one driver 610 and two resonators 620 and 630, in accordance with various embodiments. The driver may be a Pierce oscillator, in one approach. The driver is coupled on opposing sides to ground via load capacitors Cload1 and Cload2 and paths 611 and 612, respectively. One of the resonators can be selected based on the temperature, for instance. When a first switch SWV1 is closed (made conductive) and a second switch SWV2 is opened (made non-conductive), the first resonator 620 is selected. The driver and resonator 620 together form an oscillator in which the driver provides an input signal Xin (an excitation signal) to one side of the resonator on paths 611, 614 and 618, and the resonator provides an output signal Xout (A feedback signal) on the opposing side on an output node 613 and path 612. Xout can be provided to other circuits as a reference clock signal at the output node 613. SWV1 can be a relay switch or an electronic switch, e.g., a transistor. A voltage source 616 coupled to SWV1 provides a voltage Vsrc1 to control SWV1 such as to open and close it.

Similarly, to select the second resonator 630, SWV1 is opened and SWV2 is closed. A voltage source 617 coupled to SWV2 provides a voltage Vsrc2 to control SWV2 such as to open and close it. SWV2 is coupled to the driver 610 by a path 615, and to the resonator 630 by a path 619.

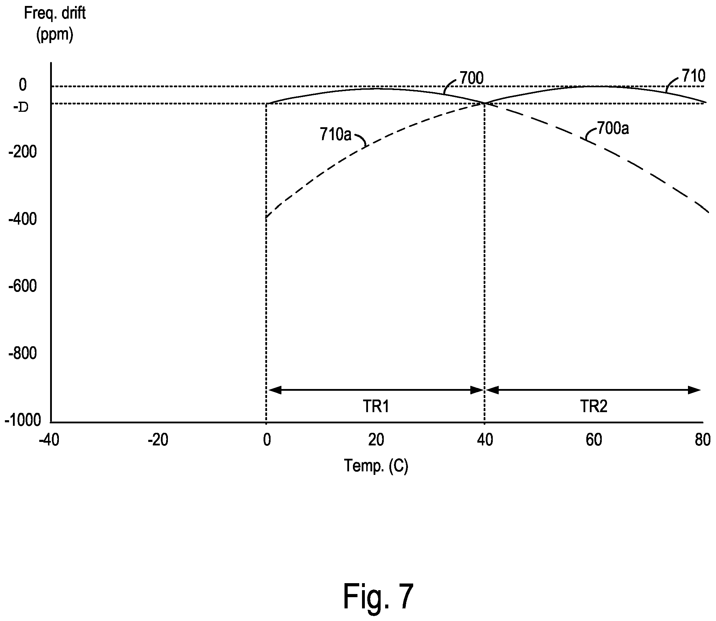

FIG. 7 depicts an example plot of frequency drift versus temperature for an array of resonators, consistent with FIG. 6, in accordance with various embodiments. In this case, the array has two resonators. A first resonator is selected when the temperature is in a first temperature range TR1, from 0 to 40 °C, and a second resonator is selected when the temperature is in a second temperature range TR2, from 40 to 80 °C. The frequency drift (plot 700) of the first resonator is within delta when the first resonator is selected, and the frequency drift (plot 710) of the second resonator is within delta when the first resonator is selected. The frequency of the first resonator decreases (plot 700a) for temperatures above TR1, while the frequency of the second resonator decreases (plot 710a) for temperatures below TR2. The temperature region of 0 to 80 is considered to be the working range of the device so that temperatures below 0 °Cor above 80 °Care not considered in this example.

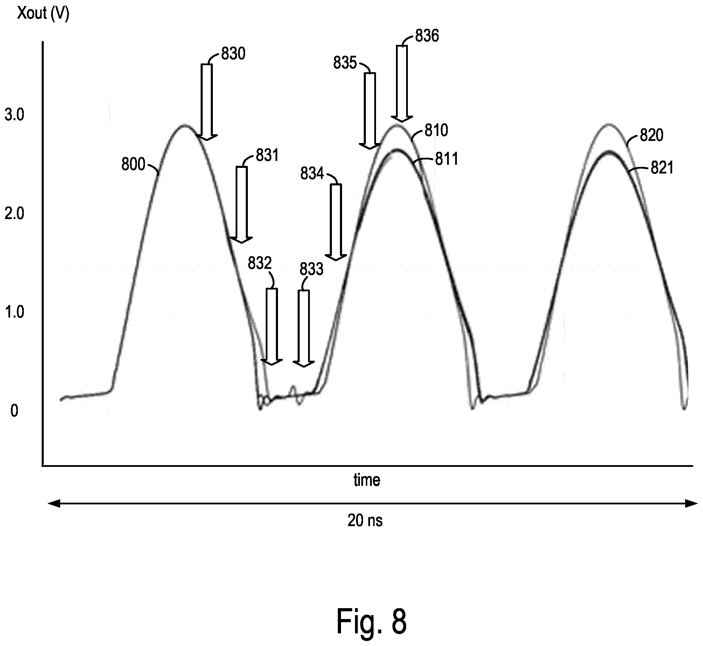

FIG. 8 depicts an example plot of an output voltage (Xout) versus time for the reference oscillator of FIG. 6, where a second resonator is added at different times, in accordance with various embodiments. The data is based on tests using the example reference oscillator 600 of FIG. 6 where the resonators were 153.6 MHz crystals from Kyocera^{™}.

The output voltage is the oscillator output with only one resonator connected and with seven different switch times, denoted by arrows 830-836, to add the second resonator. The output voltage includes three peaks. The first peak is represented by a plot 800, the second peak is represented by the plot 810 with one resonator and the plot 811 with two resonators, and the third peak is represented by the plot 820 with one resonator and the plot 821 with two resonators. The addition of the second resonator tends to reduce the peak amplitude slightly. However, the second resonator advantageously stays in phase with the first resonator. The second resonator can be added while the first resonator is running by closing the switch of the second resonator.

The plot shows that a smooth transition between resonators can be achieved by connecting both resonators to the same oscillator driver when the temperature is in a small temperature range around the switching point, such as in the hysteresis range. In this approach, only one driver may be used. The first resonator is switched off after the second resonator reaches full swing. To test the feasibility of this approach, a simplified simulation was conducted using the electrical model for two different 153.6 MHz crystals from Kyocera^{™} connected to the same oscillator driver, consistent with FIG. 6. Initially, only one crystal was connected to the driver, and in a time range of 20 ns, the switch was closed to connect the second crystal to the driver. As demonstrated, the phase change during switching is negligible regardless of the phase at which the second crystal was connected.

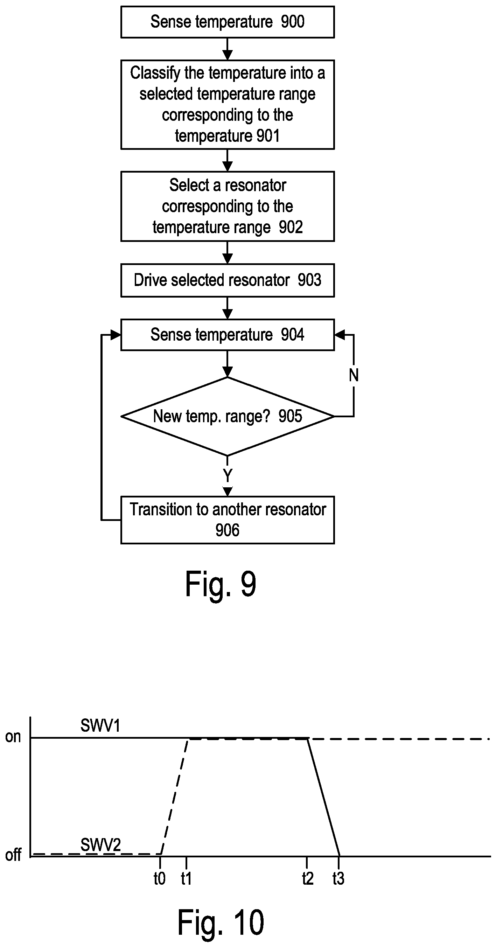

FIG. 9 depicts a flowchart of an example process for selecting a resonator in an array of resonators, in accordance with various embodiments. Block 900 involves sensing a temperature, such as using the temperature sensor 101. Block 901 includes classifying the temperature into a selected temperature range corresponding to the temperature. Block 902 includes selecting a resonator corresponding to the temperature range. The selected resonator may be considered to be a first selected resonator and can be any of the resonators discussed herein. Block 903 includes driving the selected resonator, e.g., by closing a switch which couples a driver to the selected resonator. The selected driver may be considered to be a first selected driver resonator and can be any of the drivers discussed herein. Block 904 includes again sensing the temperature. If a decision block 905 determines that a new temperature (temp.) range should be used, (Y or yes) block 906 transitions to another resonator. If the answer to the decision block is no or N, the temperature sensing continues at block 904. The new temperature range should be used when the temperature crosses a switchover temperature and, optionally, a hysteresis band of the switchover temperature, for example. The transition to the another resonator can involve a transition to another driver in some cases. In this situation, the another driver can be considered to be a second selected driver. The another resonator may be considered to be a second selected resonator.

Various techniques can be used to provide a smooth transition between different resonators in the array, thereby avoiding phase changes and glitches during the switching process.

First, one possible way to prevent phase errors during switching between resonators is to use injection locking. In this approach, each resonator has its own dedicated driver, such as in FIG. 2. When the temperature is near a switching point, the signal from the active driver (a first driver) is injected into the resonator (a second resonator) which is dedicated for use in the next temperature range. As the second oscillator's signal builds up, the injection strength is gradually reduced. This technique can accelerate the start-up time for the next oscillator and minimize the phase difference during switching. For example, see FIG. 10.

A second possible approach to transitioning between resonators initially involves connecting both resonators to the same driver concurrently when the temperature is in a small temperature range around the switching point, such as in the hysteresis range, as mentioned in connection with FIG. 8. The transition can occur when the temperature crosses a switchover temperature. One of the resonators can be disconnected after a specified/predetermined wait period after the start of the transition, for example, as discussed previously.

A third possible approach to transitioning between resonators involves frequency monitoring. In this approach, each resonator requires its own dedicated driver. When the frequency of both oscillators reaches the same value, it indicates that it is time to switch to the second oscillator. The phase difference between the two oscillators can be measured and the phase for the second oscillator can be aligned to the first oscillator. This approach can eliminate phase errors during switching and remove the need for a temperature sensor, as the switch time is determined by monitoring the oscillator frequencies.

FIG. 10 depicts example switching signals during a transition, consistent with FIG. 9, in accordance with various embodiments. Initially, SWV1 is on so that the associated first resonator is driven and active, and SWV2 is off so that the associated second resonator is not driven and is inactive. At t0, at the start of a transition from the first resonator to the second resonator, SWV2 begins to transition to the on position. At t1, SWV2 and SWV1 are both on so that the first and second resonators are both driven. At t2, SWV1 begins to turn off and reaches the off position at t3. At this time, only the second resonator is driver and the first resonator is no longer driven.

In one approach, a common driver is provided for each resonator. When there is a change from a first resonator to a second resonator based on the temperature crossing a switchover temperature, the control circuit may control the set of switches to temporarily drive both resonators concurrently. The driver can inject its output signal into the second resonator to accelerate a start-up time of the second resonator and to lock a phase of the second resonator to a phase of the first resonator. Subsequently, the switches are controlled so that the driver drives only the second resonator and discontinues driving the first resonator.

In one approach, a different driver is provided for each resonator. For example, a first driver is provided to drive a first resonator, and a second driver is provided to drive a second resonator. When the temperature changes from a first temperature range corresponding to a first turnover temperature of a first resonator to a second temperature range corresponding to a second turnover temperature of a second resonator, the control circuit is to control the set of switches to couple both the first driver and the second driver to the second resonator, then couple the second driver but not the first driver to the second resonator.

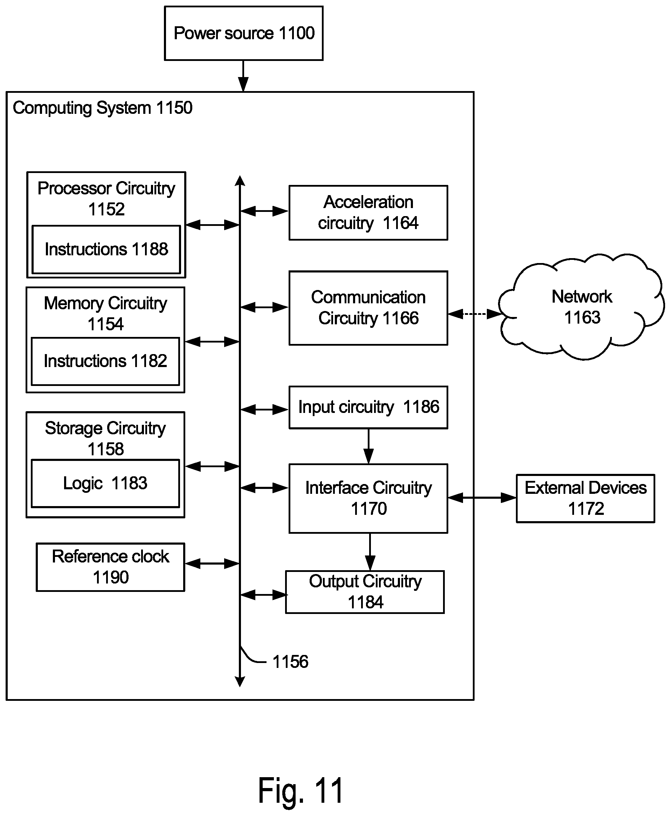

FIG. 11 illustrates an example of components that may be present in a computing system 1150 for implementing the techniques (e.g., operations, processes, methods, and methodologies) described herein. The resonators arrays and associated drivers described herein can be part of the reference clock 1190.

Communications outside the computing system may pass through the interface circuitry 1170 to the external devices 1172.

A power source 1100 such as a voltage converter may provide power to one or more of the components of the computing system 1150.

The memory circuitry 1154 may store instructions and the processor circuitry 1152 may execute the instructions to perform the functions described herein.

The computing system 1150 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1150, or as components otherwise incorporated within a chassis of a larger system. For one embodiment, at least one processor 1152 may be packaged together with computational logic 1182 and configured to practice aspects of various example embodiments described herein to form a System in Package (SiP) or a System on Chip (SoC).

System 1150 includes processor circuitry in the form of one or more processors 1152. The processor circuitry 1152 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1152 may include one or more hardware accelerators (e.g., same or similar to acceleration circuitry 1164), which may be microprocessors, programmable processing devices (e.g., FPGA, ASIC, etc.), or the like. One or more accelerators may include, for example, computer vision and/or deep learning accelerators. In some implementations, the processor circuitry 1152 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 1152 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1152 may be coupled with or may include memory/storage and may be configured to execute instructions stored in the memory/storage to enable various applications or operating systems to run on platform 1150. The processors (or cores) 1152 are configured to operate application software to provide a specific service to a user of the platform 1150. In some embodiments, the processor(s) 1152 may be a special-purpose processor(s)/controller(s) configured (or configurable) to operate according to the various embodiments herein.

As examples, the processor(s) 1152 may include an Intel@ Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel@ Corporation, Santa Clara, California. However, any number other processors may be used, such as one or more of Advanced Micro Devices (AMD) Zen@ Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1152 may be a part of a system on a chip (SoC), System-in-Package (SiP), a multi-chip package (MCP), and/or the like, in which the processor(s) 1152 and other components are formed into a single integrated circuit, or a single package, such as the Edison^{™} or Galileo^{™} SoC boards from Intel@ Corporation. Other examples of the processor(s) 1152 are mentioned elsewhere in the present disclosure.

The system 1150 may include or be coupled to acceleration circuitry 1164, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1164 may comprise logic blocks or logic fabric and other interconnected resources that may be programmed (configured) to perform various functions, such as the procedures, methods, functions, etc. of the various embodiments discussed herein. In such implementations, the acceleration circuitry 1164 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 1152 and/or acceleration circuitry 1164 may include hardware elements specifically tailored for machine learning and/or artificial intelligence (Al) functionality. In these implementations, the processor circuitry 1152 and/or acceleration circuitry 1164 may be, or may include an Al engine chip that can run many different kinds of Al instruction sets once loaded with the appropriate weightings and training code. Additionally, or alternatively, the processor circuitry 1152 and/or acceleration circuitry 1164 may be, or may include, Al accelerator(s), which may be one or more of the aforementioned hardware accelerators designed for hardware acceleration of Al applications. As examples, these processor(s) or accelerators may be a cluster of artificial intelligence (Al) GPUs, tensor processing units (TPUs) developed by Google^{®} Inc., Real Al Processors (RAPs^{™}) provided by AlphalCs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 1152 and/or acceleration circuitry 1164 and/or hardware accelerator circuitry may be implemented as Al accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 orA12 Bionic SoC, the Neural Processing Unit (NPU) within the HiSilicon Kirin 970 provided by Huawei^{®}, and/or the like. In some hardware-based implementations, individual subsystems of system 1150 may be operated by the respective Al accelerating co-processor(s), Al GPUs, TPUs, or hardware accelerators (e.g., FPGAs, ASICs, DSPs, SoCs, etc.), etc., that are configured with appropriate logic blocks, bitstream (s), etc. to perform their respective functions.

System 1150 also includes system memory 1154. Any number of memory devices may be used to provide for a given amount of system memory. As example, the memory 1154 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1154 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1154 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1158 provides persistent storage of information such as data, applications, operating systems and so forth. In an example, the storage 1158 may be implemented via a solid-state disk drive (SSDD) and/or high-speed electrically erasable memory (commonly referred to as "flash memory"). Other devices that may be used for the storage 1158 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1154 and/or storage circuitry 1158 may also incorporate three-dimensional (3D) cross-point (XPOINT) memories from Intel@ and Micron^{®}.

The memory circuitry 1154 and/or storage circuitry 1158 is/are configured to store computational logic 1183 in the form of software, firmware, microcode, or hardware-level instructions to implement the techniques described herein. The computational logic 1183 may be employed to store working copies and/or permanent copies of programming instructions, or data to create the programming instructions, for the operation of various components of system 1150 (e.g., drivers, libraries, application programming interfaces (APIs), etc.), an operating system of system 1150, one or more applications, and/or for carrying out the embodiments discussed herein. The computational logic 1183 may be stored or loaded into memory circuitry 1154 as instructions 1182, or data to create the instructions 1182, which are then accessed for execution by the processor circuitry 1152 to carry out the functions described herein. The processor circuitry 1152 and/or the acceleration circuitry 1164 accesses the memory circuitry 1154 and/or the storage circuitry 1158 over the interconnect (IX) 1156. The instructions 1182 direct the processor circuitry 1152 to perform a specific sequence or flow of actions, for example, as described with respect to the flowchart(s) and block diagram(s) of operations and functionality depicted previously. The various elements may be implemented by assembler instructions supported by processor circuitry 1152 or high-level languages that may be compiled into instructions 1188, or data to create the instructions 1188, to be executed by the processor circuitry 1152. The permanent copy of the programming instructions may be placed into persistent storage devices of storage circuitry 1158 in the factory or in the field through, for example, a distribution medium (not shown), through a communication interface (e.g., from a distribution server (not shown)), over-the-air (OTA), or any combination thereof.

The IX 1156 couples the processor 1152 to communication circuitry 1166 for communications with other devices, such as a remote server (not shown) and the like. The communication circuitry 1166 is a hardware element, or collection of hardware elements, used to communicate over one or more networks 1163 and/or with other devices. In one example, communication circuitry 1166 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally, or alternatively, communication circuitry 1166 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1156 also couples the processor 1152 to interface circuitry 1170 that is used to connect system 1150 with one or more external devices 1172. The external devices 1172 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1150, which are referred to as input circuitry 1186 and output circuitry 1184. The input circuitry 1186 and output circuitry 1184 include one or more user interfaces designed to enable user interaction with the platform 1150 and/or peripheral component interfaces designed to enable peripheral component interaction with the platform 1150. Input circuitry 1186 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1184 may be included to show information or otherwise convey information, such as sensor readings, actuator position(s), or other like information. Data and/or graphics may be displayed on one or more user interface components of the output circuitry 1184. Output circuitry 1184 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1150. The output circuitry 1184 may also include speakers and/or other audio emitting devices, printer(s), and/or the like. Additionally or alternatively, sensor(s) may be used as the input circuitry 1184 (e.g., an image capture device, motion capture device, or the like) and one or more actuators may be used as the output device circuitry 1184 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1150 may communicate over the IX 1156. The IX 1156 may include any number of technologies, including ISA, extended ISA, I2C, SPI, point-to-point interfaces, power management bus (PMBus), PCI, PCIe, PCIx, Intel@ UPI, Intel^{®} Accelerator Link, Intel@ CXL, CAPI, OpenCAPI, Intel@ QPI, UPI, Intel@ OPA IX, RapidlO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1156 may be a proprietary bus, for example, used in a SoC based system.

The number, capability, and/or capacity of the elements of system 1150 may vary, depending on whether computing system 1150 is used as a stationary computing device (e.g., a server computer in a data center, a workstation, a desktop computer, etc.) or a mobile computing device (e.g., a smartphone, tablet computing device, laptop computer, game console, loT device, etc.). In various implementations, the computing device system 1150 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read-only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: a set of resonators having different turnover temperatures; at least one driver; a set of switches to couple the at least one driver to the set of resonators; and a control circuit coupled to the set of switches, wherein the control circuit is to obtain a temperature from a temperature sensor, classify the temperature into a selected temperature range of a plurality of temperature ranges and control the set of switches to couple the at least one driver to a first selected resonator of the set of resonators having a turnover temperature in the selected temperature range.

Example 2 includes the apparatus of Example 1, wherein each of the resonators has a turnover temperature in a different temperature range of the plurality of temperature ranges.

Example 3 includes the apparatus of Example 1 or 2, wherein the plurality of temperature ranges are unequal in width and include a narrowest temperature range adjacent to wider temperature ranges.

Example 4 includes the apparatus of any one of Examples 1-3, wherein the at least one driver comprises a set of drivers, including a different driver for each resonator of the set of resonators.

Example 5 includes the apparatus of any one of Examples 1-4, wherein the control circuit is to control the set of switches to couple the at least one driver to a second selected resonator of the set of resonators when the temperature crosses a switchover temperature and a hysteresis band of the switchover temperature.

Example 6 includes the apparatus of any one of Examples 1-5, wherein each resonator of the set of resonators comprises a Microelectromechanical Systems (MEMS) resonator, and a doping concentration is different for each MEMS resonator.

Example 7 includes the apparatus of any one of Examples 1-5, wherein each resonator of the set of resonators comprises a quartz crystal resonator, and a cut angle of each quartz crystal resonator is different.

Example 8 includes the apparatus of any one of Examples 1-6, wherein each resonator of the set of resonators comprises an oxide layer, and a thickness of each oxide layer is different.

Example 9 includes the apparatus of any one of Examples 1-5, wherein each resonator of the set of resonators comprises a piezoelectric-on-silicon resonator, and a finger pitch to thickness (FP/t) ratio is different for each piezoelectric-on-silicon resonator.

Example 10 includes the apparatus of any one of Examples 1-9, further comprising at least one of an integrated circuit, a System on Chip, a System in Package or a computing device in which the set of resonators, the at least one driver, the set of switches and the control circuit are provided.

Example 11 includes an apparatus, comprising: at least one driver to drive a first resonator having a first turnover temperature and a second resonator having a second turnover temperature, different than the first turnover temperature; a set of switches coupled to the at least one driver; and a control circuit coupled to the set of switches, wherein the control circuit is to: obtain a temperature from a temperature sensor; control the set of switches to couple the at least one driver to the first resonator when the temperature is in a first temperature range corresponding to the first turnover temperature; and when the temperature changes to a second temperature range corresponding to the second turnover temperature, control the set of switches to couple the at least one driver to the second resonator.

Example 12 includes the apparatus of Example 11, wherein: the at least one driver comprises a first driver and a second driver; and the control circuit is to control the set of switches to: couple the first driver to the first resonator when the temperature is in a first temperature range; and when the temperature changes to the second temperature range, control the set of switches to couple both the first driver and the second driver to the second resonator, then couple the second driver but not the first driver to the second resonator.

Example 13 includes the apparatus of Example 12, wherein the first driver injects a signal into the second resonator to at least one of accelerate a start-up time of the second resonator or to lock a phase of the second resonator to a phase of the first resonator when the temperature changes to the second temperature range.

Example 14 includes the apparatus of Example 12 or 13, wherein the control circuit is to couple both the first driver and the second driver to the second resonator for a specified wait period.

Example 15 includes the apparatus of any one of Examples 11-14, wherein the at least one driver comprises a single driver and the control circuit is to: control the set of switches to couple the single driver to the first resonator when the temperature is in the first temperature range; and when the temperature changes to the second temperature range, control the set of switches to couple the single driver to both the first and second resonators, then couple the single driver to the second resonator but not the first resonator.

Example 16 includes the apparatus of Example 15, wherein the single driver injects a signal into the second resonator to at least one of accelerate a start-up time of the second resonator or lock a phase of the second resonator to a phase of the first resonator.

Example 17 includes an apparatus, comprising: a memory to store instructions; and a processor to execute the instructions to: obtain a temperature from a temperature sensor; determine that the temperature is in a first temperature range; and control a set of switches to couple at least one driver to a first resonator of a set of resonators based on the determination that the temperature is in a first temperature range, wherein the first resonator has a turnover temperature in the first temperature range.

Example 18 includes the apparatus of Example 17, wherein the set of resonators have different turnover temperatures.

Example 19 includes the apparatus of Example 17 or 18, wherein the processor is to execute the instructions to control the set of switches to couple the at least one driver to a second resonator of the set of resonators when the temperature changes to a second temperature range, wherein the second resonator has a turnover temperature in the second temperature range.

Example 20 includes the apparatus of Example 19, wherein the processor is to execute the instructions to control the set of switches to couple the at least one driver to both the first resonator and the second resonator concurrently when the temperature transitions from the first temperature range to the second temperature range.

Example 21 includes a method, comprising: obtaining a temperature from a temperature sensor; determining that the temperature is in a first temperature range; and controlling a set of switches to couple at least one driver to a first resonator of a set of resonators based on the determination that the temperature is in a first temperature range, wherein the first resonator has a turnover temperature in the first temperature range.

Example 22 includes the method of Example 21, wherein the set of resonators have different turnover temperatures.

Example 23 includes the method of Example 21 or 22, further comprising controlling the set of switches to couple the at least one driver to a second resonator of the set of resonators when the temperature changes to a second temperature range, wherein the second resonator has a turnover temperature in the second temperature range.

Example 24 includes the method of Example 23, further comprising controlling the set of switches to couple the at least one driver to both the first resonator and the second resonator concurrently when the temperature transitions from the first temperature range to the second temperature range.

Example 25 includes the method of Example 23 or 24, further comprising controlling the set of switches to cause the at least one driver to at least one of accelerate a start-up time of the second resonator or lock a phase of the second resonator to a phase of the first resonator.

Example 26 includes a non-transitory machine-readable storage including machine-readable instructions that, when executed, cause a processor or other circuit or computing device to implement the method of any one of Examples 21-25.

Example 27 includes a computer program comprising instructions which, when the program is executed by a computer, cause the computer to carry out the method of any one of Examples 21-25.

In the present detailed description, reference is made to the accompanying drawings that form a part hereof wherein like numerals designate like parts throughout, and in which is shown by way of illustration embodiments that may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a set of resonators having different turnover temperatures;
at least one driver;
a set of switches to couple the at least one driver to the set of resonators; and
a control circuit coupled to the set of switches, wherein the control circuit is to obtain a temperature from a temperature sensor, classify the temperature into a selected temperature range of a plurality of temperature ranges and control the set of switches to couple the at least one driver to a first selected resonator of the set of resonators having a turnover temperature in the selected temperature range.

2. The apparatus of claim 1, wherein each of the resonators has a turnover temperature in a different temperature range of the plurality of temperature ranges.

3. The apparatus of claim 1 or 2, wherein the plurality of temperature ranges are unequal in width and include a narrowest temperature range adjacent to wider temperature ranges.

4. The apparatus of any one of claims 1-3, wherein the at least one driver comprises a set of drivers, including a different driver for each resonator of the set of resonators.

5. The apparatus of any one of claims 1-4, wherein the control circuit is to control the set of switches to couple the at least one driver to a second selected resonator of the set of resonators when the temperature crosses a switchover temperature and a hysteresis band of the switchover temperature.

6. The apparatus of any one of claims 1-5, wherein each resonator of the set of resonators comprises a Microelectromechanical Systems (MEMS) resonator, and a doping concentration is different for each MEMS resonator.

7. The apparatus of any one of claims 1-6, wherein each resonator of the set of resonators comprises a quartz crystal resonator, and a cut angle of each quartz crystal resonator is different.

8. The apparatus of any one of claims 1-7, wherein each resonator of the set of resonators comprises an oxide layer, and a thickness of each oxide layer is different.

9. The apparatus of any one of claims 1-8, wherein each resonator of the set of resonators comprises a Thickness-Lame mode piezoelectric-on-silicon resonator, and a finger pitch to thickness (FP/t) ratio is different for each Thickness-Lame mode piezoelectric-on-silicon resonator.

10. The apparatus of any one of claims 1-9, further comprising at least one of an integrated circuit, a System on Chip, a System in Package or a computing device in which the set of resonators, the at least one driver, the set of switches and the control circuit are provided.

11. An apparatus, comprising:
at least one driver to drive a first resonator having a first turnover temperature and a second resonator having a second turnover temperature, different than the first turnover temperature;
a set of switches coupled to the at least one driver; and
a control circuit coupled to the set of switches, wherein the control circuit is to:
obtain a temperature from a temperature sensor;
control the set of switches to couple the at least one driver to the first resonator when the temperature is in a first temperature range corresponding to the first turnover temperature; and
when the temperature changes to a second temperature range corresponding to the second turnover temperature, control the set of switches to couple the at least one driver to the second resonator.

12. The apparatus of claim 11, wherein:
the at least one driver comprises a first driver and a second driver; and
the control circuit is to control the set of switches to:
couple the first driver to the first resonator when the temperature is in a first temperature range; and
when the temperature changes to the second temperature range, control the set of switches to couple both the first driver and the second driver to the second resonator, then couple the second driver but not the first driver to the second resonator.

13. The apparatus of claim 12, wherein the first driver injects a signal into the second resonator to at least one of accelerate a start-up time of the second resonator or to lock a phase of the second resonator to a phase of the first resonator when the temperature changes to the second temperature range.

14. The apparatus of claim 12 or 13, wherein the control circuit is to couple both the first driver and the second driver to the second resonator for a specified wait period.

15. The apparatus of any one of claims 12-14, wherein the at least one driver comprises a single driver and the control circuit is to:
control the set of switches to couple the single driver to the first resonator when the temperature is in the first temperature range; and
when the temperature changes to the second temperature range, control the set of switches to couple the single driver to both the first and second resonators, then couple the single driver to the second resonator but not the first resonator.
